# EUROPEAN PATENT APPLICATION

(11) **EP 4 443 445 A1**
(43) Date of publication of application: **09.10.2024**
(21) Application number: 22921553.8
(22) Date of filing: 21.10.2022
(51) Int. Cl.: H01B 7/04, H01B 7/00, H01B 13/00, H01B 13/008, H01B 13/22

(54) **CONNECTION LINE STRUCTURE AND FORMING METHOD THEREFOR**

(30) Priority: 21.01.2022 CN 202210072846
(71) Applicant: Wuhan Neuracom Technology Development Co., Ltd, Wuhan, Hubei 430200 (CN)
(72) Inventor: HUANG, Li, Wuhan, Hubei 430200 (CN); HUANG, Cheng, Wuhan, Hubei 430200 (CN); MA, Zhanfeng, Wuhan, Hubei 430200 (CN); WANG, Yaqin, Wuhan, Hubei 430200 (CN); WANG, Chunshui, Wuhan, Hubei 430200 (CN); GAO, Jianfei, Wuhan, Hubei 430200 (CN)
(74) Representative: Osterhoff, Utz
(86) International application number: PCT/CN2022/126566
(87) International publication number: WO 2023/138129

(57) **Abstract**

Disclosed are a connection line structure and a forming method thereof. The connection line structure comprises a passivation layer, a metal layer, and a protective layer, the metal layer is arranged on the passivation layer, and the protective layer is arranged on the metal layer. In the present application, a simple single-layer wiring design may be utilized, and a multi-layer three-dimensional wiring design may also be utilized to implement high speed transmission, a MEMS process allows for design of a connection line in a straight or bent layout, a connection line of a bent layout is flexible, and better compatibility is achieved.

## Description

### TECHNICAL FIELD

The present application relates to the technical field of connection lines. More specifically, the present application relates to a connection line structure and a forming method thereof.

### BACKGROUND

The flexible flat cable (FFC) can arbitrarily select the number and spacing of wires, making wiring convenient and reducing the size of electronic products, which is suitable for use as data transmission cables between moving parts and motherboards, between print circuit boards (PCB), and in miniaturized electrical equipment.

The flexible flat cables are used in imaging modules to connect the print circuit board & assembly (PCBA, which is an electronic component produced by electronic printing technology) and the connector. The signal of the chip on the PCBA is connected to the flexible flat cable through the pin, and the flexible flat cable transmits the signal to the connector. The connector can be connected to the driver board, the processor, etc., so as to realize signal communication between the chip and the outside.

The micro-electro-mechanical system (MEMS) technology is an emerging technology that uses silicon as the main material and internal dimensions of the micro-electro-mechanical devices are in micrometers and submicrometers. The MEMS technology can produce micro devices with complex three-dimensional structures such as movable and suspended structures. Using MEMS technology to produce signal transmission cables to replace traditional flexible flat cables will greatly reduce the size of the cables and reduce product size.

### SUMMARY

The purpose of the present application is to provide a connection line structure and a forming method thereof, which can select different MEMS configurations according to the required transmission rate.

In order to achieve these objects and other advantages of the present application, a connection line structure is provided, including: a passivation layer, a metal layer and a protective layer. The metal layer is provided on the passivation layer, and the protective layer is provided on the metal layer.

In an embodiment, the metal layer includes at least one metal line.

In an embodiment, the metal line is in a shape of linear, wavy, square wave or zigzag.

In an embodiment, the connection line structure further includes at least two welding plates provided at both ends of the metal line.

In an embodiment, the connection line structure further includes multiple metal layers and multiple protective layers, and the metal layers and the protective layers are alternately stacked.

In order to achieve these objects and other advantages of the present application, a method for forming a connection line structure is provided, including:
step A: forming a passivation layer on a substrate;
step B: forming a metal layer on the passivation layer; and
step C: forming a protective layer on the metal layer;
where the connection line structure is formed through a semiconductor process.

In an embodiment, the method further includes:
removing part of the substrate.

In an embodiment, the method further includes:
forming multiple metal layers and multiple protective layers through step B and step C,
where the metal layers and the protective layers are alternately stacked.

In an embodiment, the method further includes:
forming a contact hole on the protective layer.

In an embodiment, the method further includes:
forming a welding plate in response to that the first metal layer is formed on the passivation layer.

The present application at least includes the following beneficial effects:
1. Using the MEMS technology to produce connection lines, the internal dimensions can be at the micron and sub-micron level. Compared with traditional connection lines, the overall size of the connection lines can be reduced by 2 to 4 levels of magnitude, thereby reducing product size.
2. Using a multi-layer three-dimensional design, there is no need to reduce the number of wires, and the overall size of the connecting wire can be further reduced.
3. The metal wire can adopt a curved design. The curved metal wire is flexible and can meet the connection between moving parts.
4. The MEMS connecting wires are produced using the MEMS technology, which enables mass production and greatly reduces costs.
5. The MEMS connecting wires can be produced using silicon-based processes or other semiconductor processes. Currently, most chips are produced using silicon-based semiconductor processes, thus the MEMS connecting wires are easier to integrate with chips.

Other advantages, objects and features of the present application will be revealed in part from the description below, and will be understood by those skilled in the art from study and practice of the application.

### BRIEF DESCRIPTION OF THE DRAWINGS

FIG. 1 is a cross-sectional view of a metal layer and a welding plate produced on a substrate in a first embodiment.
FIG. 2 is a top view of the metal layer and the welding plate in the first embodiment.
FIG. 3 is a cross-sectional view of a passivation protective layer in the first embodiment.
FIG. 4 is a top view of FIG. 3.
FIG. 5 is a cross-sectional view after removing part of the substrate in the first embodiment.
FIG. 6 is a bottom view of FIG. 5.
FIG. 7 is a cross-sectional view of a first metal layer and a PAD produced in a second embodiment.
FIG. 8 is a top view of FIG. 7.
FIG. 9 is a cross-sectional view of a second metal layer produced in the second embodiment.
FIG. 10 is a top view of FIG. 9.
FIG. 11 is a cross-sectional view of a third metal layer produced in the second embodiment.
FIG. 12 is a top view of FIG. 11;
FIG. 13 is a cross-sectional view with a welding plate exposed in the second embodiment.
FIG. 14 is a top view of FIG. 13.
FIG. 15 is a cross-sectional view of a flexible connection line formed by removing a substrate material under the first metal layer in the second embodiment.
FIG. 16 is a bottom view of FIG. 15.

Reference signs: 1 substrate, 2 first metal layer, 3 first protective layer, 4 straight metal line, 5 wavy metal line, 6 square metal line, 7 welding plate, 8 contact hole, 9 second metal layer, 10 second protective layer, 11 third metal layer, 12 third protective layer.

### DETAILED DESCRIPTION OF THE EMBODIMENTS

The following is a further detailed description of the present application with reference to the attached drawings, so that those skilled in the art can implement according to the content of the specification.

In order to make the purpose, the technical solution and the advantage of the present application clearer, the present application will be described in more detail below with reference to the accompanying drawings and embodiments. It should be understood that specific embodiments described herein are intended only to explain the present application and are not intended to limit it.

It should be noted that if there are directional indications, such as up, down, left, right, front, back, etc, involved in the embodiments of the present application, the directional indications are only used to explain the relative position relationship, movement, etc. between the components in a particular attitude (as shown in the attached drawings). If the specific posture changes, the directional indication also changes accordingly.

### The first embodiment

This embodiment provides a connection line structure, including a passivation layer, a metal layer and a protective layer. The metal layer is provided on the passivation layer, and the protective layer is provided on the metal layer. The metal layer includes at least one metal line, that is, the metal layer includes one metal line, or the metal layer includes at least two independent metal lines. The connection line structure is formed through a semiconductor process, which includes a micro-electro-mechanical system (MEMS) process, and the connection line structure is flexible and can be bent.

In an embodiment, the shape of the metal line is linear, wavy, square wave or zigzag.

In other embodiments, the connection line structure includes multiple metal layers and multiple protective layers, and the metal layer and the protective layer are alternately stacked.

In this embodiment, the connection line structure includes at least two welding plates provided at both ends of the metal line.

### The second embodiment

Combined with the first embodiment, this embodiment provides a method for forming a connection line structure, including:
Step A: forming a passivation layer on the substrate.
Step B: forming a metal layer on the passivation layer.
Step C: forming a protective layer on the metal layer.

The connection line structure is formed through a semiconductor process.

After the metal layer and protective layer are formed, part of the substrate is removed, and part of the substrate can be retained at both ends.

In an embodiment, steps B and C are used to form multiple metal layers and multiple protective layers, and the metal layers and protective layers are alternately stacked.

Further, while forming the first metal layer on the passivation layer, multiple welding plates are also formed, and electrical contacts are formed with corresponding units through the welding plates.

After each protective layer is formed, multiple contact holes are formed on the protective layer corresponding to the position of the welding plate, and the projection of the contact hole on the first metal layer covers the corresponding welding plate. After the next metal layer is formed on the protective layer, the corresponding contact hole will also be filled with metal, thereby forming an electrical connection between the metal layer and the corresponding welding plate. When the metal layer includes multiple metal lines, both ends of each metal line are connected to the welding plate through corresponding contact holes.

### The third embodiment

Combined with the aforementioned first embodiment and the second embodiment, the method of producing a single-layer connection line structure using the MEMS technology is specifically described.

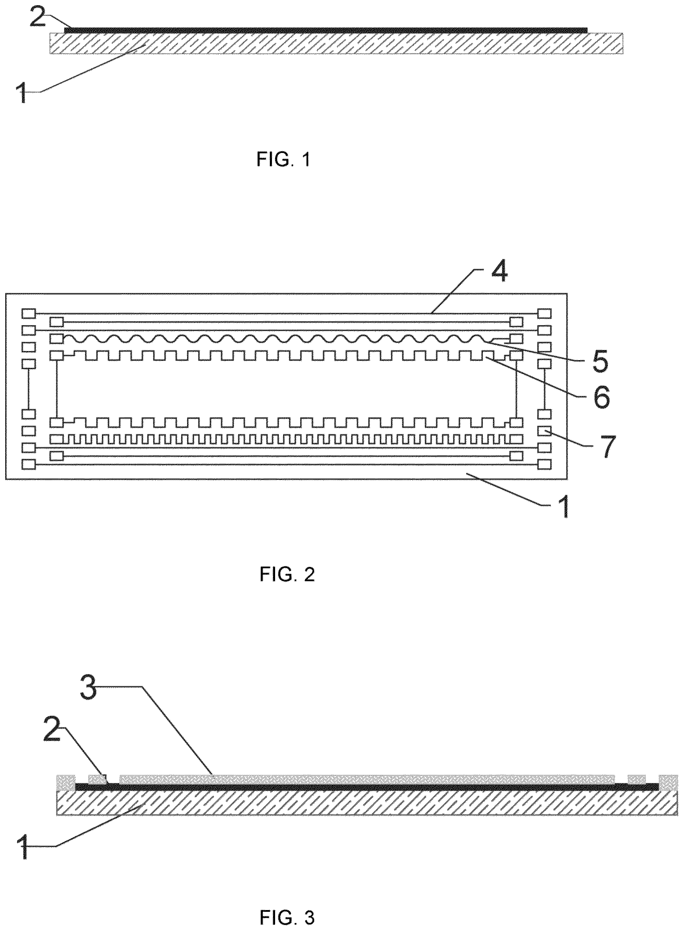

Referring to FIG. 1 to FIG. 2, the first metal layer 2 and welding plate 7 are produced on the substrate 1. The substrate 1 can be selected from silicon, silicon-on-insulator (SOI), glass and other materials. In an embodiment, the passivation layer can be first plated on the substrate 1 to protect the metal layer. The metal layer can be formed of titanium, aluminum, copper and other metal materials. The metal layer includes at least one metal line. The metal line can be a straight metal line 4 or a curved metal line, and the curved metal line can be a wavy metal line 5, a square metal line 6 or a zigzag metal line. The metal layer is produced using the MEMS technology, and the width of each metal line is 0.1 un to 50um. The welding plate 7 is used to communicate with external connections, and is made of the same metal as the metal layer. The welding plate 7 and the metal layer are formed simultaneously in one process.

Referring to FIG. 3 to FIG. 4, the first protective layer 3 is plated on the first metal layer 2. The first protective layer 3 can be SiO₂ or Si₃N₄. The first protective layer 3 needs to be patterned using photolithography and other processes to expose the welding plate 7.

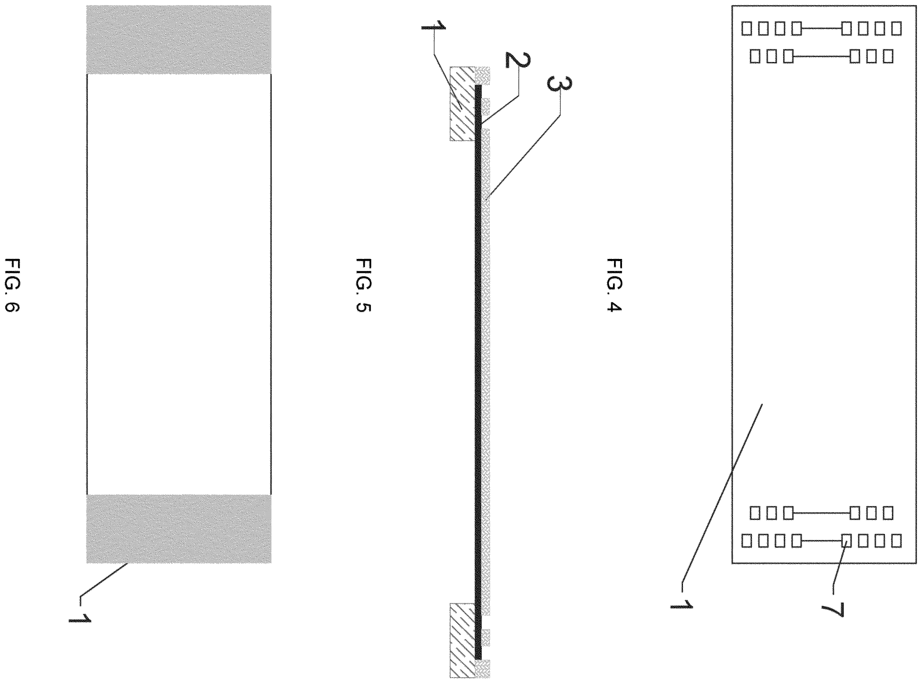

Referring to FIG. 4 to FIG. 6, the substrate 1 under the first metal layer 2 is removed through photolithography, deep etching or wet etching processes, leaving only part of the substrate 1 at both ends to form a suspended connection line structure. The suspended connection line structure is flexible and suitable for signal connection between movable parts.

After using the MEMS process to form the suspended connection line structure, an insulating layer can be coated on the upper and lower sides of the connection line structure to protect the connection line structure and ensure that the connection line structure is not easy to break and has better anti-corrosion and toughness.

### The fourth embodiment

Combined with the aforementioned first embodiment and the second embodiment, the method of producing a multi-layer connection line structure using the MEMS technology is specifically described.

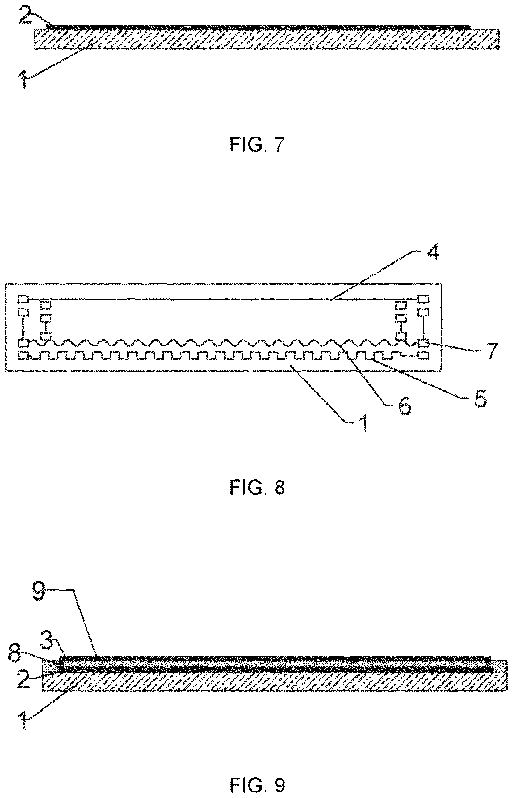

Referring to FIG. 7 to FIG. 8, the first metal layer 2 and the welding plate 7 are produced on the substrate 1. Similar to the single-layer connection line in the first embodiment, the metal layer includes at least one metal line, and the metal line can be the straight metal line 4 or the curved connection line. The curved connection line can be the wavy metal line 5, the square metal line 6 or the zigzag metal line, etc. The metal layer is produced by the MEMS technology, and the width of each metal line is 0.1un to 50um. The welding plate 7 is used to communicate with external connections, and is made of the same metal as the metal layer. The welding plate 7 and the metal layer are formed simultaneously in one process.

Referring to FIG. 9 to FIG. 10, the first protective layer 3 is first plated on the first metal layer 2, and the first protective layer 3 is etched to form the contact hole 8. The second metal layer 9 is produced on the first protective layer 3. The second metal layer 9 is connected to the welding plate 7 through the contact hole 8.

The position of the contact hole 8 and the method of filling the metal in the contact hole can refer to the aforementioned third embodiment, and will not be described here again.

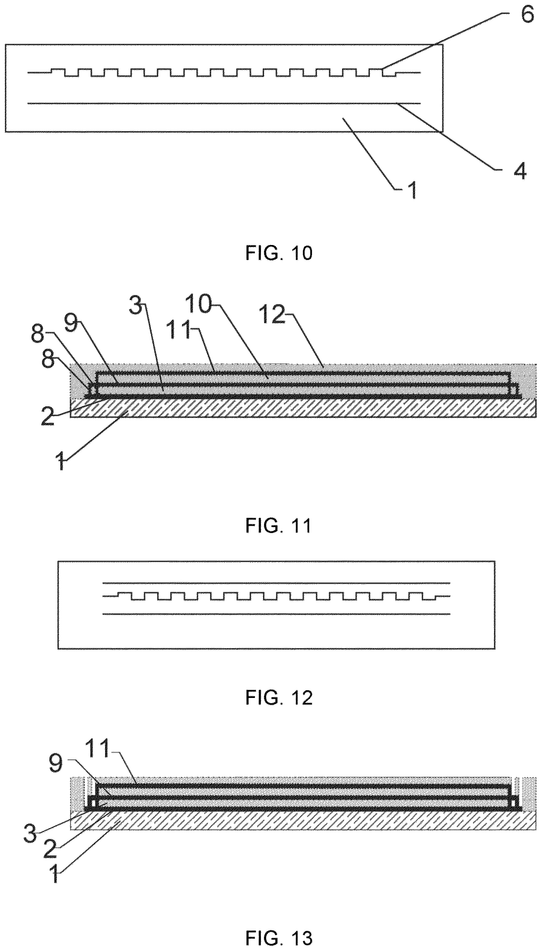

Referring to FIG. 11 to FIG. 12, the second protective layer 10 is first plated on the second metal layer 9, and the second protective layer 10 is etched to form the contact hole 8. The third metal layer 11 is produced on the second protective layer 10, and a third protective layer 15 needs to be plated on the third metal layer 11 to form protection. According to the production steps of the protective layer, the contact hole 8, and the metal layer, a fourth layer, a fifth layer and other more metal layers can be designed.

Referring to FIG. 13 to FIG.14, after completing the production of multiple metal layers, the passivation protective layer on the outermost surface is etched to expose the welding plate 7, which is used for communication with the outside world.

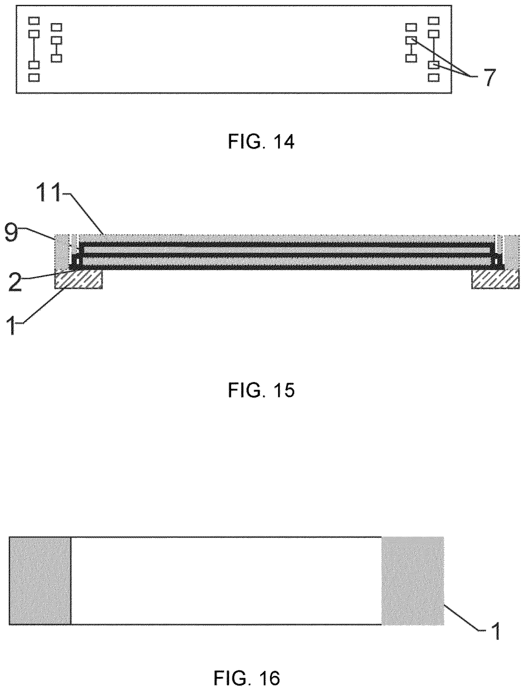

Referring to FIG. 15 to FIG.16, the substrate material under the connection line is removed, and only the substrate material at both ends is remained. The purpose is the same as removing the substrate material from the single-layer MEMS connection line.

The method of producing soft connection lines using the MEMS technology in this application can adopt a simple single-layer wiring design, or a multi-layer three-dimensional wiring design to achieve high-speed transmission. The MEMS technology allows the connection lines to be designed in a straight line or a bent configuration, and the connecting cable with the bent configuration is flexible and has a better matching performance.

The above content is a further detailed description of the present application in combination with embodiments. It cannot be concluded that the specific implementation of the present application is limited to these descriptions. For those skilled in the art to which the present application belongs, several simple deductions or substitutions can be made without departing from the concept of the present application, which shall be deemed to fall within the present application.

## Claims

1. A connection line structure, **characterized by** comprising a passivation layer, a metal layer and a protective layer, wherein the metal layer is provided on the passivation layer, and the protective layer is provided on the metal layer.

2. The connection line structure according to claim 1, wherein the metal layer comprises at least one metal line.

3. The connection line structure according to claim 2, wherein the metal line is in a shape of linear, wavy, square wave or zigzag.

4. The connection line structure according to claim 2, further comprising at least two welding plates provided at both ends of the metal line.

5. The connection line structure according to claim 1, further comprising multiple metal layers and multiple protective layers, and the metal layers and the protective layers are alternately stacked.

6. A method for forming a connection line structure, **characterized by** comprising:
step A: forming a passivation layer on a substrate;
step B: forming a metal layer on the passivation layer; and
step C: forming a protective layer on the metal layer;
wherein the connection line structure is formed through a semiconductor process.

7. The forming method according to claim 6, further comprising:
removing part of the substrate.

8. The forming method according to claim 6, further comprising:
forming multiple metal layers and multiple protective layers through step B and step C,
wherein the metal layers and the protective layers are alternately stacked.

9. The forming method according to claim 8, further comprising:
forming a contact hole on the protective layer.

10. The forming method according to claim 8, further comprising:
forming a welding plate in response to that the first metal layer is formed on the passivation layer.
